# EUROPEAN PATENT APPLICATION

(11) **EP 2 320 468 A1**
(43) Date of publication of application: **11.05.2011**
(21) Application number: 09808042.7
(22) Date of filing: 11.08.2009
(51) Int. Cl.: H01L 29/786, H01L 21/336

(54) **SEMICONDUCTOR DEVICE, METHOD FOR MANUFACTURING SEMICONDUCTOR DEVICE, TRANSISTOR SUBSTRATE, LIGHT EMITTING DEVICE AND DISPLAY DEVICE**

(30) Priority: 19.08.2008 JP 2008211096
(71) Applicant: Sumitomo Chemical Company, Limited, Tokyo 104-8260 (JP)
(72) Inventor: FUKUHARA, Noboru, Tsukuba-shi Ibaraki 305-0035 (JP); HASEGAWA, Akira, Tsukuba-shi Ibaraki 305-0821 (JP); MATSUMURO, Tomonori, Tsukuba-shi Ibaraki 305-0051 (JP)
(74) Representative: Jackson, Martin Peter
(86) International application number: PCT/JP2009/003867
(87) International publication number: WO 2010/021106

(57) **Abstract**

A technique is disclosed to stabilize the threshold voltage of a transistor having an active layer formed of a metal oxide. The transistor includes a first metal oxide layer, a second metal oxide layer that is greater in sheet resistance than the first metal oxide layer, a pair of an input electrode and an output electrode that are electrically connected to the first metal oxide layer, and a control electrode that controls an impedance between the input electrode and the output electrode. The control electrode, the first metal oxide layer, and the second metal oxide layer are arranged in the stated order.

## Description

### TECHNICAL FIELD

The present invention relates to a semiconductor device, a method for manufacturing a semiconductor device, a transistor substrate, a light emitting device, and a display device. More particularly, the present invention relates to a semiconductor device having a semiconductor active layer formed of a metal oxide, a method for manufacturing such a semiconductor device, a transistor substrate, a light emitting device, and a display device. The present application relates to the following Japanese Patent Application, the contents of which are incorporated herein by reference, if applicable.
Japanese Patent Application No. 2008-211096 filed on August 19, 2008

### BACKGROUND ART

In recent years, semiconductor devices having a semiconductor active layer formed of metal oxides are expected to be used as driving transistors in display devices or the like, in particular, as pixel driving transistors. Oxide semiconductors can be manufactured at low temperatures and exhibit high carrier mobility Furthermore, oxide semiconductors can be transparent to visible light. Thus, oxide semiconductors can be utilized, for example, to form a semiconductor active layer in transparent thin film transistors (TFTs) that are designed to drive the pixels of display devices. Patent Document 1 discloses a thin film transistor (TFT) that can operate in a normally-off mode by having a semiconductor active layer made of an amorphous oxide whose electron carrier concentration is less than 10¹⁸ /cm³. Specifically speaking, this TFT uses an amorphous oxide of InGaO₃(ZnO)ₘ (*m* is a natural number less than 6), and the amorphous oxide with the electron carrier concentration being less than 10¹⁸ /cm³ is deposited by controlling the partial pressure of oxygen during the deposition. The active layer made of the amorphous oxide has a first region and a second region that is positioned closer to a gate insulator than the first region, and the oxygen concentration is higher in the second region than in the first region.
Patent Document 1: Japanese Patent Application Publication No. 2006-165529

### DISCLOSURE OF THE INVENTION

### PROBLEMS TO BE SOLVED BY THE INVENTION

The above-described conventional transistor, however, disadvantageously has an unstable threshold voltage since oxygen defects easily occur and carrier electrons are likely to be generated. Therefore, the objective of the present invention is to provide a transistor having a stable threshold voltage while having an active layer formed of an oxide semiconductor.

### MEANS FOR SOLVING THE PROBLEMS

The inventors of the present invention were dedicated to solve the above-mentioned problems and succeeded in making the present invention. A first embodiment of the present invention provides a semiconductor device including a first oxide layer, a second oxide layer that is greater in sheet resistance than the first oxide layer, a pair of an input electrode and an output electrode that are electrically connected to the first oxide layer, and a control electrode that controls an impedance between the input electrode and the output electrode. Here, the control electrode, the first oxide layer, and the second oxide layer are arranged in the stated order. The first and second oxide layers may be formed of metal oxides. In the following description, the first oxide layer and the second oxide layer may be sometimes respectively referred to as a first metal oxide layer and a second metal oxide layer.

Referring to the above-described semiconductor device, the first metal oxide layer may contain at least zinc (Zn) or tin (Sn). The second metal oxide layer may contain at least one of the metal elements contained in the first metal oxide layer. The second metal oxide layer may have a sheet resistance exceeding 1 × 10⁵ Ω/square. The first metal oxide layer may contain at least one element selected from a group of elements consisting of In, Sn, Zn, and Mg, and the second metal oxide layer may be substantially free from In. The first metal oxide layer may contain In. In the first metal oxide layer, the In concentration may vary in the thickness direction, such that the closer to the control electrode, the higher the In concentration.

Referring to the above-described semiconductor device, the first metal oxide layer may be higher in carrier mobility than the second metal oxide layer. The second metal oxide layer may have a higher concentration of oxygen than the first metal oxide layer. The second metal oxide layer may be greater in the energy gap of a forbidden band than the first metal oxide layer. The second metal oxide layer may contain a metal element that constitutes an oxide that generates carriers a majority of which are holes, and the second metal oxide layer may have a higher concentration of the metal element than the first metal oxide layer. The second metal oxide layer may contain at least one element selected from a group of elements consisting of Al, Zr, Mo, Cr, W, Nb, Ti, Ga, Hf, Ni, Ag, V, Ta, Fe, Cu, Pt, Si, and F.

A second embodiment of the present invention provides a method for manufacturing a semiconductor device, including providing a substrate, forming a first metal oxide layer, forming a second metal oxide layer that is greater in sheet resistance than the first metal oxide layer, forming a pair of an input electrode and an output electrode that are electrically connected to the first metal oxide layer, and forming a control electrode that controls an impedance between the input electrode and the output electrode.

A third embodiment of the present invention provides a transistor substrate including a first metal oxide layer, a second metal oxide layer that is greater in sheet resistance than the first oxide layer, a pair of an input electrode and an output electrode that are electrically connected to the first metal oxide layer, and a control electrode that controls an impedance between the input electrode and the output electrode. Here, the control electrode, the first metal oxide layer, and the second metal oxide layer are arranged in the stated order.

A fourth embodiment of the present invention provides a light emitting device including a light emitting element, and a semiconductor device that is coupled to the light emitting element and controls the light emission of the light emitting element. The semiconductor device includes a first metal oxide layer, a second metal oxide layer that is greater in sheet resistance than the first metal oxide layer, a pair of an input electrode and an output electrode that are electrically connected to the first metal oxide layer, and a control electrode that controls an impedance between the input electrode and the output electrode. The control electrode, the first metal oxide layer, and the second metal oxide layer are arranged in the stated order.

A fifth embodiment of the present invention provides a display device including a pixel, and a semiconductor device that is coupled to the pixel and controls the display of the pixel. The semiconductor device includes a first metal oxide layer, a second metal oxide layer that is greater in sheet resistance than the first metal oxide layer, a pair of an input electrode and an output electrode that are electrically connected to the first metal oxide layer, and a control electrode that controls an impedance between the input electrode and the output electrode. The control electrode, the first metal oxide layer, and the second metal oxide layer are arranged in the stated order.

### EFFECT OF THE INVENTION

The present invention can provide a transistor having a stable threshold voltage while having an active layer formed of an oxide semiconductor. Additionally, the present invention can advantageously form a semiconductor active layer with a reduced amount of In, which is a scarce metal resource, and thus provides industrial advantages.

### BRIEF DESCRIPTION OF THE DRAWINGS

Fig. 1 schematically illustrates, as an example, the cross-section of a thin film transistor 100.
Fig. 2 schematically illustrates, as an example, a cross-section observed during the manufacturing process of the thin-film transistor 100.
Fig. 3 schematically illustrates, as an example, a cross-section observed during the manufacturing process of the thin-film transistor 100.
Fig. 4 schematically illustrates, as an example, a cross-section observed during the manufacturing process of the thin-film transistor 100.
Fig. 5 schematically illustrates, as an example, a cross-section observed during the manufacturing process of the thin-film transistor 100.
Fig. 6 schematically illustrates, as an example, the cross-section of a thin film transistor 600.
Fig. 7 is an exemplary schematic circuit diagram illustrating a light emission display device 700.
Fig. 8 schematically illustrates, as an example, the cross-section of the light emission display device 700.
Fig. 9 illustrates, as an example, the measured transmittance spectra of zinc tin oxide films.

### DESCRIPTION OF REFERENCE NUMERALS

- 100: thin film transistor
- 110: substrate
- 112: main surface
- 120: control electrode
- 130: insulating layer
- 132: gate contact opening
- 140: metal oxide layer
- 142: first metal oxide layer
- 144: second metal oxide layer
- 150: input and output electrodes
- 152: source electrode
- 154: drain electrode
- 600: thin film transistor
- 610: substrate
- 612: main surface
- 620: control electrode
- 630: insulating layer
- 640: metal oxide layer
- 642: first metal oxide layer
- 644: second metal oxide layer
- 650: input and output electrodes
- 652: source electrode
- 654: drain electrode
- 700: light emission display device
- 702: power supply line
- 704: gate line
- 706: driving transistor
- 708: light emitting pixel
- 810: substrate
- 812: main surface
- 820: control electrode
- 830: insulating layer
- 840: metal oxide layer
- 842: first metal oxide layer
- 844: second metal oxide layer
- 852: source electrode
- 854: drain electrode
- 872: light emitting layer
- 874: top electrode
- 880: cap film
- 890: extended electrode

### BEST MODE FOR CARRYING OUT THE INVENTION

Some aspects of the invention will now be described based on the embodiments, which do not intend to limit the scope of the present invention, but exemplify the invention. All of the features and the combinations thereof described in the embodiment are not necessarily essential to the invention.

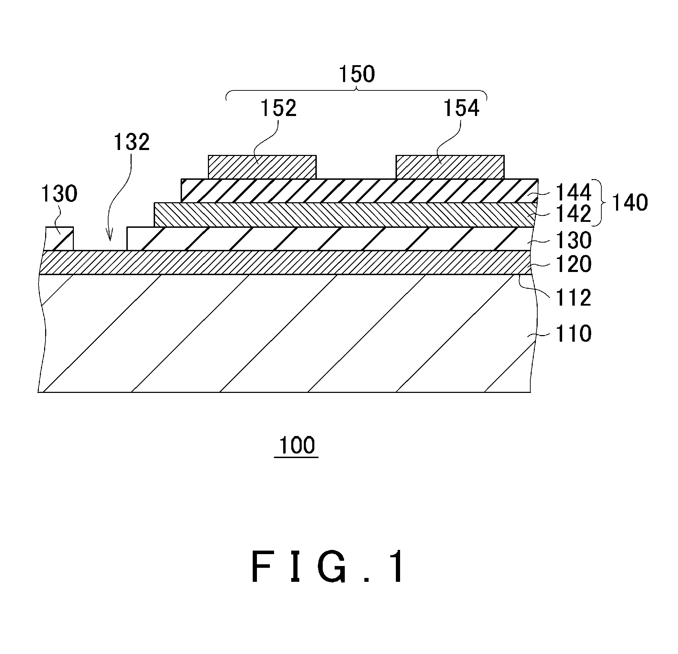

Fig. 1 schematically illustrates, as an example, the cross-section of a thin film transistor 100. The thin film transistor 100 is an example of the semiconductor device relating to an embodiment of the present invention. The thin film transistor 100 includes a substrate 110, a control electrode 120, an insulating layer 130, a metal oxide layer 140, and input and output electrodes 150. The insulating layer 130 may have a gate contact opening 132. The metal oxide layer 140 may have a first metal oxide layer 142 and a second metal oxide layer 144. The input and output electrodes 150 may be a pair of a source electrode 152 and a drain electrode 154. The substrate 110, the control electrode 120, the insulating layer 130, the first metal oxide layer 142, the second metal oxide layer 144, and the input and output electrodes 150 may be arranged in the stated order in the direction substantially perpendicular to one main surface 112 ofthe substrate 110 in at least part of the region in which the input and output electrodes 150 are formed.

The substrate 110 may have insulating properties. The substrate 110 may be flexible, and transparent or translucent to visible light. The substrate 110 may be one of an Si substrate, a sapphire substrate, and a glass substrate, or a less heat-resistant substrate than these substrates. The substrate 110 may be a substrate made of organic materials such as polyethylene, polyethylene terephthalate (PET), glass made of a polymer material, and a polymer film.

The control electrode 120 generates an electric field to control the carrier spatial distribution within the first metal oxide layer 142, thereby controlling the impedance between the input electrode 150 and the output electrode 150. The control electrode 120 may be formed of electrically conductive materials such as metals including Al, Cu, Mo, Ni, and Au, and highly-doped polysilicon. The control electrode 120 may be formed of transparent electrically conductive materials that are transparent or translucent to visible light, including indium oxide, tin oxide, zinc oxide, zinc tin oxide, and indium tin oxide.

The control electrode 120 can be formed by, for example, CVD or sputtering. Between the control electrode 120 and the insulating layer 130, an adhesive layer may be formed to improve the adhesive connection between the control electrode 120 and the insulating layer 130. The adhesive layer may contain Ti, Cr, Ni. It should be noted here that, when used herein, "doping" refers not only to the process of generating carriers in structure-sensitive materials such as Si but also to the process of changing the composition of oxides such as metal oxides, and that "dopants" refers to the elements to be injected during doping.

The insulating layer 130 electrically insulates the control electrode 120 and the first metal oxide layer 142 from each other. The insulating layer 130 may be formed of insulating materials that are transparent or translucent to visible light. Such insulating materials may include inorganic and organic insulating materials. The inorganic insulating materials may include, for example, insulating ZnO, SiN, SiO₂, Al₂O₃, MgO, CeO₂, and SiO₂. Insulating ZnO can be obtained by doping ZnO with elements that can be monovalent or Group VB elements and further with 3d transition metal elements. The organic insulating materials may include, for example, polyimide, resins, polymer films. The insulating layer 130 can be formed by, for example, CVD, sputtering, or coating.

The insulating layer 130 may have a gate contact opening 132 that penetrates through the insulating layer 130 in the direction substantially perpendicular to one of the main surfaces of the substrate 110. Through the gate contact opening 132, the control electrode 120 is electrically connected to an external power supply, which is not shown.

In the present embodiment, the control electrode 120 and the first metal oxide layer 142 are arranged with the insulating layer 130 being disposed therebetween so as to be electrically insulated from each other. The present invention, however, is not limited to such. As an alternative example, the insulating layer 130 may have a layered structure constituted by two or more different materials. This layered structure may include a combination of inorganic and organic insulating materials.

The first metal oxide layer 142 contains metal oxides. The first metal oxide layer 142 is electrically connected to the source electrode 152 and the drain electrode 154 so as to form an active region between the source electrode 152 and the drain electrode 154, thereby acting as a semiconductor active layer. Specifically speaking, the electric field generated by the control electrode 120 controls the carrier spatial distribution within the first metal oxide layer 142, which controls the impedance of the active region formed within the first metal oxide layer 142. The first metal oxide layer 142 may be formed of amorphous metal oxides or crystalline metal oxides including microcrystals, for example. For example, when the substrate 110 has low heat resistance, the first metal oxide layer 142 may be formed of amorphous metal oxides. Alternatively when the substrate 110 is a glass substrate, the first metal oxide layer 142 may be formed of crystalline metal oxides.

The first metal oxide layer 142 may contain metal oxides that are transparent or translucent to visible light. The first metal oxide layer 142 may be formed, for example, from In₂O₃, SnO₂, ZnO, InGaO₃(ZnO)ₘ (*m* is a natural number less than 6). Other examples of the metal oxides that are transparent or translucent to visible light may include indium tin oxide (ITO), indium zinc oxide (ZIO), indium zinc oxide (IZO), indium tungsten oxide (IWO), aluminum-doped zinc oxide (AZO), gallium-doped zinc oxide (GZO), fluorine-doped zinc oxide (FZO), antimony-doped tin oxide (ATO), fluorine-doped tin oxide (FTO), magnesium oxide (MgO), gallium indium oxide (GIO), zinc indium tin oxide (ZITO), zinc tin oxide (ZTO), and zinc magnesium oxide. It should be noted here that, when used herein, the term "metal" refers not only to metal elements and transition metal elements but also to metalloid elements such as B, Si, Ge and As.

The first metal oxide layer 142 may contain at least zinc (Zn) or tin (Sn). The first metal oxide layer 142 may contain both Zn and Sn. Adding Sn to a metal oxide containing Zn reduces the deliquescence of the metal oxide. For example, the first metal oxide layer 142 can be formed by sputtering by using as the sputtering target a sintered body whose composition ratio between zinc oxide and tin oxide is adjusted in advance. Here, the first metal oxide layer 142 may be formed by sputtering under an oxygen atmosphere. The first metal oxide layer 142 may alternatively be formed by RF sputtering. For example, sputtering may be performed while a gas containing dopants is being supplied in the vicinity of the substrate 110 to form the first metal oxide layer 142 doped with the dopants.

The first metal oxide layer 142 may contain at least one element selected from a group of elements consisting of In, Sn, Zn and Mg. The first metal oxide layer 142 may contain In. The inventors of the present invention have discovered that the electron mobility and carrier concentration of a metal oxide containing at least Zn or Sn may increase when indium (In) is added to the metal oxide. By using a metal oxide containing In to form a region of the thin film transistor 100 in which a channel is to be formed, the thickness of the first metal oxide layer 142 can be reduced so as to become only slightly larger than the thickness of the channel during the ON state of the transistor. During the ON state of the transistor, the channel formed in the interface between the insulating layer 130 and the first metal oxide layer 142 may have a thickness of approximately 1 to 2 nm.

It is desirable to reduce the thickness of the first metal oxide layer 142 in terms of the process efficiency As the thickness of the first metal oxide layer 142 decreases, however, the characteristics of the thin film transistor 100 becomes more susceptible to oxygen deficiency in the vicinity of the channel or external damages. Thus, it becomes more difficult to reduce the variation in the characteristics of the thin film transistor 100. To address this issue, the active layer of the thin film transistor 100 may be constituted by the first metal oxide layer 142 and the second metal oxide layer 144 that has a higher resistance than the first metal oxide layer 142, and the first metal oxide layer 142, which is positioned closer to the control electrode 120 than the second metal oxide layer 144, may be formed of a metal oxide with In being added thereto, for example. In this manner, even if the first metal oxide layer 142 has a smaller thickness, the variation in the characteristics of the thin film transistor 100 can be reduced with it being possible to maintain the performance of the thin film transistor 100. Since the first metal oxide layer 142 is allowed to have a smaller thickness, the present embodiment can be realized by using a smaller amount of In, which is a scarce metal.

The second metal oxide layer 144 may be substantially free from In. Thus, the amount of In used to form the thin film transistor 100 can be further reduced. It should be noted here that, when used herein, the expression "substantially free from" refers not only to a case where the In concentration in the second metal oxide layer 144 is no more than the measurable limit, but also to a case where the second metal oxide layer 144 inevitably contains In as impurities due to the manufacturing process or a case where In contained in the first metal oxide layer 142 or the input and output electrodes 150 is diffused into the second metal oxide layer 144 and the second metal oxide layer 144 resultantly contains In.

The first metal oxide layer 142 may have a thickness no less than 3 nm and no more than 50 nm, preferably no less than 3 nm and no more than 10 nm, more preferably no less than 3 nm and no more than 5 nm. When the thickness of the first metal oxide layer 142 falls short of 3 nm, the first metal oxide layer 142 suffers from significant fluctuations in the form of the thin film and becomes more susceptible to the second metal oxide layer 144. Thus, the mobility of the first metal oxide layer 142 decreases. On the other hand, when the thickness of the first metal oxide layer 142 exceeds 50 nm, an increase in the thickness of the first metal oxide layer 142 does not significantly improve the performance of the thin film transistor 100.

The elemental In concentration in the first metal oxide layer 142 may vary in the layer thickness direction, more specifically, in the direction substantially perpendicular to one of the main surfaces of the substrate 110. For example, the closer to the control electrode 120, the higher the elemental In concentration. In this manner, addition of In produces more effects since a layer with a high mobility can be formed in the vicinity of the control electrode 120. For example, the concentration of elemental In can be varied in the layer thickness direction by adding a target during the deposition process by sputtering. As an alternative example, the concentration of elemental In can be varied in the layer thickness direction by varying the partial pressure of the dopant-containing gas during the deposition process by RF sputtering.

The metal oxides are prone to oxygen deficiency and have conduction carriers. The conduction carriers vary the threshold voltage of the transistor. As the conduction carriers are positioned farther away from the control electrode, the conduction carriers more significantly varies the threshold voltage of the transistor. Reducing the thickness of the metal oxides can reduce the influence of the conduction carriers on the threshold voltage of the transistor. As the thickness of the metal oxides decreases, however, it becomes more difficult to reduce the variation in the characteristics of the thin film transistor 100 as described above. Furthermore, a high oxygen concentration in the metal oxides destabilizes the charge injection from the input and output electrodes electrically connected to the metal oxides.

To address the above issues, the active layer of the thin film transistor 100 may be constituted by the first metal oxide layer 142 and the second metal oxide layer 144 that has a higher resistance than the first metal oxide layer 142, and the second metal oxide layer 144 may be higher in oxygen concentration than the first metal oxide layer 142, which is positioned closer to the control electrode 120 than the second metal oxide layer 144, for example. This can prevent the conduction carriers from being generated in the region distant from the control electrode 120. As a consequence, even if the first metal oxide layer 142 has a smaller thickness, the variation in the characteristics of the thin film transistor 100 can be reduced with it being possible to maintain the performance of the thin film transistor 100. For example, the oxygen concentration can be increased in the first metal oxide layer 142 by increasing the partial pressure of the oxygen within the reaction container during the deposition process by sputtering.

The second metal oxide layer 144 may contain a metal oxide greater in sheet resistance than the first metal oxide layer 142. The control electrode 120, the first metal oxide layer 142, and the second metal oxide layer 144 are arranged in the stated order in at least part of the thin film transistor 100. As described above, arranging the second metal oxide layer 144 greater in sheet resistance on the surface of the first metal oxide layer 142 that faces away from the control electrode 120 can stabilize the threshold voltage of the thin film transistor 100 with it being possible to maintain the performance of the thin film transistor 100. The second metal oxide layer 144 may be in contact with the first metal oxide layer 142.

The second metal oxide layer 144 may be higher in oxygen concentration than the first metal oxide layer 142. In this manner, the second metal oxide layer 144 can be greater in sheet resistance than the first metal oxide layer 142. The second metal oxide layer 144 may have a sheet resistance exceeding 1 × 10⁵ Ω/□. The SI unit of sheet resistance is [Ω], but other units such as [Ω/□] or [Ω/Sq] may be used herein to represent sheet resistance.

Table 1 shows the relation between the oxygen concentration in the gas supplied during the deposition, the sheet resistance, the sheet carrier concentration, and the hole mobility for zinc tin oxide. Zinc tin oxide was deposited by RF sputtering by using as a target a sintered body of zinc tin oxide. The sintered body used as the target was prepared by weighing powders of ZnO (available from Kojundo Chemical Laboratory Co., Ltd, the purity is 99.9%) and SnO₂ (available from Kojundo Chemical Laboratory Co., Ltd, the purity is 99.9%) in a mole ratio of 2:1, and then subjecting ZnO and SnO₂ to blending in a dry ball mill, first baking (at 900 C°, for five hours), dry grinding, pressure-forming, and second baking (at 1013 hPa, at 1200 C° and for five hours). The obtained sintered body had a density of 5.43 g/cm³. The surfaces of the obtained sintered body were polished by using a surface grinder to prepare the target.

The above-described target and a glass substrate (available from Coming, 1737) were placed within a chamber of a sputtering apparatus, and sputtering was then performed while a gas containing oxygen and argon (Ar) was supplied to the chamber. The sputtering operation was controlled to continue for one hour with the pressure within the chamber being set to 0.5 Pa, the substrate temperature being set to 200 C°, and the sputtering power being set to 50W. The zinc tin oxide obtained by the sputtering operation was an n-type semiconductor and had a thickness of 103 to 105 nm. For Run 1 to Run 4, the partial pressure of the oxygen in the supplied gas was varied to vary the oxygen concentration in the supplied gas. For Run 1 to Run 4, the oxygen concentration in the supplied gas was set at 0 vol%, 0.1 vol%, 1 vol%, and 10 vol% as shown in Table 1.

The sheet resistance, the sheet carrier concentration, and the hole mobility were measured by using a ResiTest 8300 measuring system available from TOYO Corporation at room temperature in a darkroom with the magnetic filed being set to 0.5T. As seen from Table 1, the sheet resistance increased as the oxygen concentration in the metal oxide increased. Furthermore, the sheet carrier concentration and the hole mobility decreased as the oxygen concentration in the metal oxide increased.

**<Table1>**

| | **SAMPLES** | | **MEASUREMENTS** | | |
|---|---|---|---|---|---|
| **No.** | **COMPOSITION OF TARGET** | **OXYGEN CONCENTRATION** [vol %] | **SHEET RESISTANCE** [Ω/□] | **SHEET CARRIER CONCENTRATION** [cm⁻²] | **HOLE MOBILITY** [cm⁻²/Vs] |
| **Run. 1** | Zn₂SnO₄ | 0 | 5.73 × 10³ | 7.27 × 10¹³ | 14.9 |
| **Run. 2** | Zn₂SnO₄ | 0.1 | 1.18 × 10⁵ | 4.89 × 10¹² | 10.8 |
| **Run. 3** | Zn₂SnO₄ | 1 | 2.85 × 10⁶ | 3.59 × 10¹¹ | 6.11 |
| **Run. 4** | Zn₂SnO₄ | 10 | 2.56 × 10⁷ | 4.85 × 10¹⁰ | 5.02 |

The second metal oxide layer 144 may contain at least one element selected from a group of elements consisting of Al, Zr, Mo, Cr, W, Nb, Ti, Ga, Hf, Ni, Ag, V, Ta, Fe, Cu, Pt, Si, and F. When any of these elements are included in the second metal oxide layer 144, the sheet resistance of the second metal oxide layer 144 increases.

Table 2 s shows how the sheet resistance of zinc tin oxide varies when the metal oxide is doped with dopants. The zinc tin oxide was deposited by RF sputtering by using a sintered body of zinc tin oxide as a sputtering target The target and a glass substrate (available from Coming, 1737) were placed within a chamber of a sputtering apparatus.

To dope the zinc tin oxide with dopants other than Ga or F, a chip containing the dopants was disposed on the erosion portion of the target. The chip had a size of 5 mm × 5 mm and a thickness of 1 mm. The dopants contained in the chip had a purity of 99.9 % or higher. To dope the zinc tin oxide with Ga, a sintered body pellet of gallium oxide (Ga₂O₃) was disposed in place of the chip. The sintered body pellet had a diameter of 10 mm and a thickness of 3 mm. To dope the zinc tin oxide with F, a sintered body pellet of Zn₂SnO₄ doped with zinc fluoride (ZnF₂) and tin fluoride (SnF₄) was disposed in place of the chip. The sintered body pellet had a (ZnF₂) and tin fluoride (SnF₄) was disposed in place of the chip. The sintered body pellet had a diameter of 10 mm and a thickness of 3 mm.

After the glass substrate, the target and the chip were placed within the sputtering apparatus, sputtering was performed while an argon (Ar) gas was being supplied to the chamber to deposit the metal oxide on the glass substrate. The sputtering operation was controlled to continue for one hour with the pressure within the chamber being set to 0.5 Pa, the substrate temperature being set to 200 C°, and the sputtering power being set to 50W The zinc tin oxide obtained by the sputtering operation had a thickness of 104 nm to 116 nm.

The sheet resistance was measured at room temperature by using a ResiTest 8300 measuring system available from TOYO Corporation. As seen from Table 2, metal oxides containing at least one element selected from a group of elements consisting of Al, Zr, Mo, Cr, W, Nb, Ti, Ga, Hf, Ni, Ag, V, Ta, Fe, Cu, Pt, Si, and F was greater in sheet resistance than metal oxides containing none of the above-mentioned elements.

**<Table2>**

| **DOPANT ELEMENTS** | **SHEET RESISTANCE** |
|---|---|
| | [Ω/□] |
| NONE | 3.05E+03 |
| Al | 9.18E+03 |
| Zr | 1.06E+04 |
| Mo | 1.13E+04 |
| Cr | 1.25E+04 |
| W | 1.50E+04 |
| Nb | 1.54E+04 |
| Ti | 1.69E+04 |
| Ga | 1.90E+04 |
| Hf | 2.34E+04 |
| Ni | 2.50E+04 |
| Si | 2.99E+04 |
| Ag | 3.25E+04 |
| V | 4.30E+04 |
| Ta | 8.80E+04 |
| Fe | 1.06E+05 |
| F | 1.20E+05 |
| Cu | 2.55E+07 |
| Pt | 7.13E+07 |

The second metal oxide layer 144 may contain at least one of the metal elements contained in the first metal oxide layer 142. For example, when the first metal oxide layer 142 contains Zn and Sn, the second metal oxide layer 144 may also contain Zn and Sn. In this way, an excellent interface is formed between the first metal oxide layer 142 and the second metal oxide layer 144, which can prevent the characteristics of the thin film transistor 100 from degrading.

The second metal oxide layer 144 may contain metal oxides that are transparent or translucent to visible light. The second metal oxide layer 144 may be formed of amorphous or crystalline metal oxides. For example, when the substrate 110 has low heat resistance, the second metal oxide layer 144 may be formed of amorphous metal oxides. Alternatively, when the substrate 110 is a glass substrate, the second metal oxide layer 144 may be formed of crystalline metal oxides.

The second metal oxide layer 144 may have a thickness of no less than 10 nm and no more than 100 nm. The second metal oxide layer 144 having a thickness smaller than 10 nm is unlikely to produce the above-described effects. On the other hand, the second metal oxide layer 144 having a thickness exceeding 100 nm provides poorer cost-effectiveness. Furthermore, the second metal oxide layer 144 having a thickness exceeding 100 nm is not desirable since conduction carriers are more likely to be generated in a region distant from the control electrode 120. The total thickness of the first metal oxide layer 142 and the second metal oxide layer 144 may not exceed 100 nm.

The present embodiment stabilizes the threshold voltage of the thin film transistor 100 by setting the sheet resistance of the second metal oxide layer 144 higher than the sheet resistance of the first metal oxide layer 142. However, there may be other configurations to stabilize the threshold voltage of the thin film transistor 100. For example, the second metal oxide layer 144 may be lower in carrier mobility than the first metal oxide layer 142. This alternative configuration can also stabilize the threshold voltage of the thin film transistor 100 by reducing the influence of the conduction carriers in the second metal oxide layer 144 on the threshold voltage of the transistor. For example, the carrier mobility of the second metal oxide layer 144 may be controlled to be lower than the carrier mobility of the first metal oxide layer 142 by setting the elemental In concentration in the second metal oxide layer 144 lower than the elemental In concentration in the first metal oxide layer 142.

Furthermore, the threshold voltage of the thin film transistor 100 may also be stabilized by setting the energy gap of the forbidden band of the second metal oxide layer 144 larger than the energy gap of the forbidden band of the first metal oxide layer 142. Specifically speaking, this configuration may be achieved by adding at least one element selected from a group of elements consisting of Be, Mg, B, Al, Ga, C, Si, and Ge to the second metal oxide layer 144 to control the concentration of the added elements to be higher in the second metal oxide layer 144 than in the first metal oxide layer 142, for example. Preferably, Ga, Al may be added.

Furthermore, the second metal oxide layer 144 may contain a metal element that constitutes a metal oxide that generates carriers a majority of which are holes, and the concentration of this metal element may be controlled to be higher in the second metal oxide layer 144 than in the first metal oxide layer 142. This metal element may be preferably Mo, Ni, Cu, most preferably Cu. This configuration may be capable of controlling the resistance of the second metal oxide layer 144 to increase.

The source electrode 152 and the drain electrode 154 may be an example ofthe pair of the input and output electrodes 150 that are electrically connected to the first metal oxide layer 142. The source electrode 152 and the drain electrode 154 may be formed of a similar material to the control electrode 120. In the present embodiment, the input and output electrodes 150 are electrically connected to the first metal oxide layer 142 with the second metal oxide layer 144 intervening therebetween, but the present invention is not limited to such. For example, between the second metal oxide layer 144 and the input and output electrodes 150, a layer may be formed which establishes an ohmic contact with the second metal oxide layer 144. The input and output electrodes 150 may be formed by a plurality of layers and establish an ohmic contact with the second metal oxide layer 144 or the first metal oxide layer 142.

In the present embodiment, the thin film transistor 100 is a so-called inverted staggered thin film transistor (TFT). The thin film transistor 100, however, is not limited to such. For example, the thin film transistor 100 may be a staggered TFT, a coplanar TFT, or an inverted coplanar TFT. Furthermore, the control electrode 120, the insulating layer 130, the metal oxide layer 140 and the input and output electrodes 150 may be first formed on a highly heat-resistant substrate and then transferred to a poorly heat-resistant substrate.

The above description discloses a transistor substrate including the thin film transistor 100. Specifically speaking, the transistor substrate includes a first metal oxide layer, a second metal oxide layer that is greater in sheet resistance than the first metal oxide layer, a pair of an input electrode and an output electrode that are electrically connected to the first metal oxide layer, and a control electrode that controls the impedance between the input electrode and the output electrode. The control electrode, the first metal oxide layer, and the second metal oxide layer are arranged in the stated order.

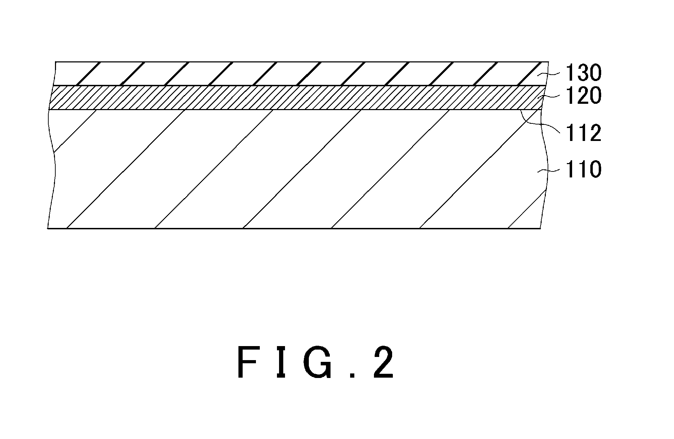

Fig. 2 schematically illustrates, as an example, a cross-section observed during the manufacturing process of the thin-film transistor 100. As shown in Fig. 2, the substrate 110 is first provided. The substrate 110 may be a glass substrate, a glass substrate made of a polymer material, a plastic substrate, or a polymer film. Subsequently, on the side of one main surface 112 of the substrate 110, the control electrode 120 and the insulating layer 130 are formed. The control electrode 120 and the insulating layer 130 may be formed such that the substrate 110, the control electrode 120, and the insulating layer 130 are arranged in the stated order in the direction substantially perpendicular to the main surface 112 on at least part of the substrate 110.

The control electrode 120 may be formed of electrically conductive materials such as metals including Al, Cu, Mo, Ni, and Au, or highly-doped polysilicon. Alternatively, the control electrode 120 may be formed of transparent electrically conductive materials that are transparent or translucent to visible light, including indium oxide, tin oxide, zinc oxide, zinc tin oxide, and indium tin oxide. For example, the control electrode 120 can be formed by sputtering. The control electrode 120 may be patterned by using photolithography or lift-off technique, for example.

The insulating layer 130 may be formed of insulating ZnO, SiN, SiO₂, Al₂O₃, MgO, CeO₂, SiO₂, polyimide, or a polymer film. The insulating layer 130 can be formed, for example, by CVD, sputtering or coating.

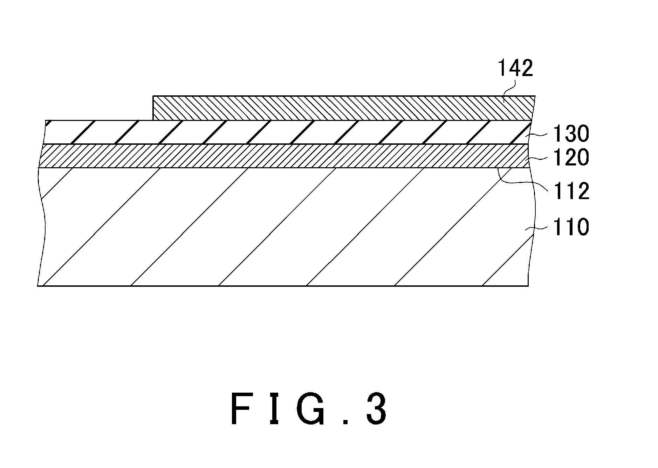

Fig. 3 schematically illustrates, as an example, a cross-section observed during the manufacturing process of the thin-film transistor 100. As shown in Fig. 3, on the side of the main surface 112 of the substrate 110, the first metal oxide layer 142 is formed. The first metal oxide layer 142 may be formed such that the substrate 110, the control electrode 120, the insulating layer 130 and the first metal oxide layer 142 are arranged in the stated order in the direction substantially perpendicular to the main surface 112 on at least part of the substrate 110. The first metal oxide layer 142 may be formed of transparent electrically-conductive metal oxides such as ITO, ZITO, ZIO, GIO, ZTO, FTO, AZO, and GZO, for example.

The first metal oxide layer 142 can be formed by sputtering, for example. To perform the sputtering operation, a gas mixture of a rare gas and oxygen may be supplied to the reaction container.

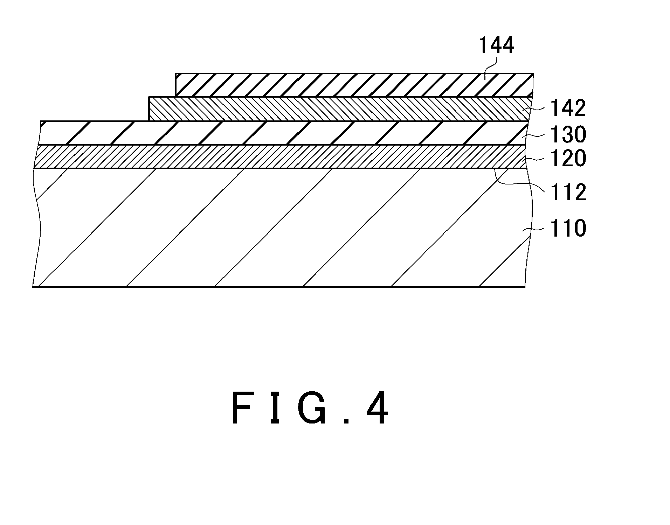

Fig. 4 schematically illustrates, as an example, a cross-section observed during the manufacturing process of the thin-film transistor 100. As shown in Fig. 4, on the side of the main surface 112 of the substrate 110, the second metal oxide layer 144 is formed. The second metal oxide layer 144 may be formed such that the substrate 110, the control electrode 120, the insulating layer 130, the first metal oxide layer 142, and the second metal oxide layer 144 are arranged in the stated order in the direction substantially perpendicular to the main surface 112 on at least part of the substrate 110. For example, the second metal oxide layer 144 may be formed of metal oxides free from In such as tin oxide, zinc oxide, zinc tin oxide, or the In-free metal oxides doped with dopants, which may be, for example, at least one element selected from a group of elements consisting of Al, Zr, Mo, Cr, W, Nb, Ti, Ga, Hf, Ni, Ag, V, Ta, Fe, Cu, Pt, Si, and F.

The second metal oxide layer 144 can be formed by sputtering, for example. The second metal oxide layer 144 may be successively formed after the first metal oxide layer 142 is formed without vacuum break in the chamber of the sputtering apparatus. The partial pressure of the oxygen in the supplied gas may be set higher during the step of forming the second metal oxide layer 144 than during the step of forming the first metal oxide layer 142.

The second metal oxide layer 144 may be formed by reactive sputtering with a gas containing dopants being supplied to the chamber. The dopants may be, for example, at least one element selected from a group of elements consisting of Al, Zr, Mo, Cr, W, Nb, Ti, Ga, Hf, Ni, Ag, V, Ta, Fe, Cu, Pt, Si, and F. Alternatively, the dopants may be at least one element selected from a group of elements consisting of Be, Mg, B, C and Ge. The partial pressure of the gas containing the dopants in the supplied gas may be set higher during the step of forming the second metal oxide layer 144 than during the step of forming the first metal oxide layer 142.

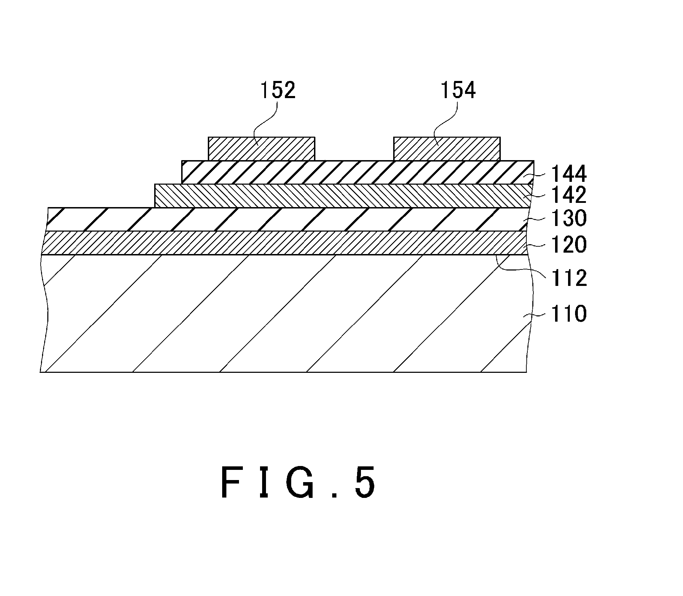

Fig. 5 schematically illustrates, as an example, a cross-section observed during the manufacturing process of the thin-film transistor 100. As shown in Fig. 5, on the side of the main surface 112 of the substrate 110, the source electrode 152 and the drain electrode 154 are formed. The source electrode 152 and the drain electrode 154 may be an example of the input and output electrodes 150. The source electrode 152 and the drain electrode 154 may be formed such that the substrate 110, the control electrode 120, the insulating layer 130, the first metal oxide layer 142, the second metal oxide layer 144 and the input and output electrode 150 are arranged in the stated order in the direction substantially perpendicular to the main surface 112 on at least part of the substrate 110. The input and output electrodes 150 may be formed of a similar material and in a similar manner to the control electrode 120. The gate contact opening 132 is then formed in the insulating layer 130, so that the thin film transistor 100 is manufactured.

The above description discloses a method for manufacturing a thin film transistor, including providing a substrate, forming a first metal oxide layer, forming a second metal oxide layer that is greater in sheet resistance than the first metal oxide layer, forming a pair of an input electrode and an output electrode that are electrically connected to the first metal oxide layer, and forming a control electrode that controls an impedance between the input electrode and the output electrode. In the present embodiment, providing the substrate 110, forming the control electrode 120, forming the first metal oxide layer 142, forming the second metal oxide layer 144, and forming the pair of the input and output electrodes 150 are performed in the stated order. However, the order of performing the respective steps is not limited to the above and can be appropriately adapted depending on the structure of a desired semiconductor device.

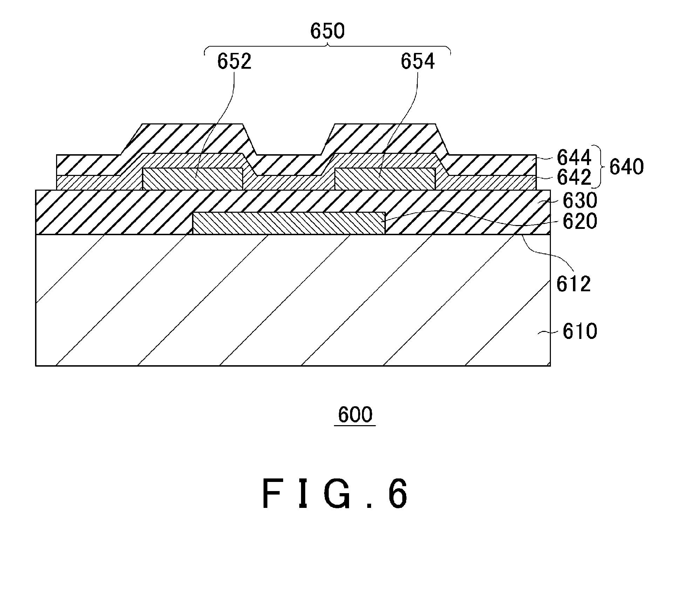

Fig. 6 schematically illustrates, as an example, the cross-section of a thin film transistor 600 relating to another embodiment. The thin film transistor 600 may be an example of the semiconductor device. The thin film transistor 600 may be an inverted-coplanar TFT. The thin film transistor 600 is constituted by a substrate 610, a control electrode 620, an insulating layer 630, a metal oxide layer 640, and a pair of input and output electrodes 650. The metal oxide layer 640 may include a first metal oxide layer 642 and a second metal oxide layer 644. The pair of the input and output electrodes 650 may include a source electrode 652 and a drain electrode 654.

The substrate 610, the control electrode 620, the insulating layer 630, the first metal oxide layer 642, and the second metal oxide layer 644 may be arranged in the stated order in the direction substantially perpendicular to one main surface 612 of the substrate 610 in at least part of the thin film transistor 600. The active region formed between the source electrode 652 and the drain electrode 654 may be formed by at least part ofthe first metal oxide layer 642. For example, the source electrode 652, the first metal oxide layer 642, and the drain electrode 654 may be arranged in the stated order in the direction substantially parallel with one of the main surfaces of the substrate 610 in at least part of the thin film transistor 600.

The substrate 610, the main surface 612, the control electrode 620, the insulating layer 630, the metal oxide layer 640, the first metal oxide layer 642, the second metal oxide layer 644, the input and output electrodes 650, the source electrode 652, and the drain electrode 654 in the thin film transistor 600 are respectively counterparts of the substrate 110, the main surface 112, the control electrode 120, the insulating layer 130, the metal oxide layer 140, the first metal oxide layer 142, the second metal oxide layer 144, the input and output electrodes 150, the source electrode 152, and the drain electrode 154 in the thin film transistor 100. Each constituent ofthe thin film transistor 600 can be formed of a similar material, manufactured in a similar manner, and used for a similar purpose to the corresponding constituent of the thin film transistor 100.

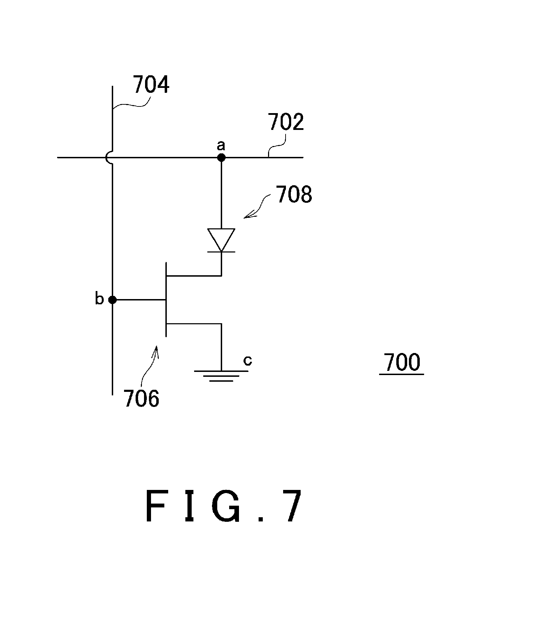

Fig. 7 is an exemplary schematic circuit diagram illustrating a light emission display device 700. The light emission display device 700 may be an example of the display device. Other examples of the display deice may include, for example, a liquid crystal display device. The light emission display device 700 may be an example of the light emitting device. Other examples of the light emitting device may include, for example, an illumination panel such as a backlight for a liquid crystal screen. The light emission display device 700 includes a power supply line 702, a gate line 704, a driving transistor 706, and a light emitting pixel 708. The driving transistor 706 may be an example of the semiconductor device. The driving transistor 706 controls the currents used to drive the light emitting pixel 708 according to the signal on the gate line 704. The light emitting pixel 708 may be an example ofthe pixel. The light emitting pixel 708 may be an example of the light emitting element. The light emitting pixel 708 may be a light emitting device such as a light emitting diode or a laser diode. The gate of the driving transistor 706 may be connected to, in place of the gate line 704, a scan line for pixel selection and a data line for pixel information, and a switching transistor connected to a data accumulation capacitor. In this case, the switching transistor may be fabricated in the same step as the driving transistor 706.

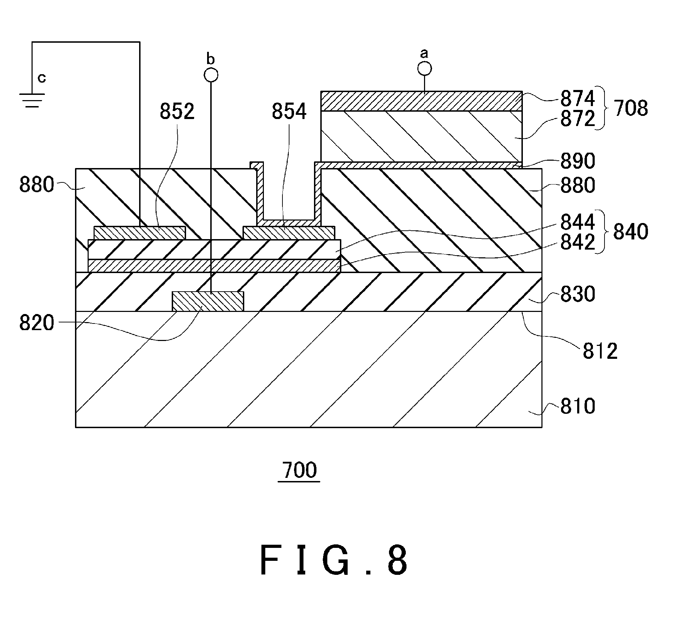

Fig. 8 schematically illustrates, as an example, the cross-section of the light emission display device 700. The locations designated by the reference marks *a, b* and *c* in Fig. 8 respectively correspond to the locations designated by the reference marks *a, b* and *c* in Fig. 7. The light emission display device 700 includes a substrate 810, the driving transistor 706, and the light emitting pixel 708. The driving transistor 706 includes a control electrode 820, an insulating layer 830, a metal oxide layer 840, a source electrode 852, and a drain electrode 854. In at least part of the driving transistor 706, the control electrode 820, the insulating layer 830, the first metal oxide layer 842, and the second metal oxide layer 844 may be arranged in the stated order in the direction substantially perpendicular to one main surface 812 of the substrate 810.

The substrate 810, the main surface 812, and the control electrode 820 of the driving transistor 706 are counterparts of the substrate 110, the main surface 112 and the control electrode 120 of the thin film transistor 100. The control electrode 820 may be formed of electrically conductive materials such as metals including Al, Cu, Mo, Ni, and Au and highly-doped polysilicon. Alternatively, the control electrode 820 may be formed of transparent electrically-conductive materials that are transparent or translucent to visible light, such as indium oxide, tin oxide, zinc oxide, zinc tin oxide, and indium tin oxide.

The insulating layer 830 of the driving transistor 706 is a counterpart of the insulating layer 130 of the thin film transistor 100. The metal oxide layer 840 includes the first metal oxide layer 842 and the second metal oxide layer 844. The metal oxide layer 840, the first metal oxide layer 842, and the second metal oxide layer 844 of the driving transistor 706 are respectively counterparts of the metal oxide layer 140, the first metal oxide layer 142, and the second metal oxide layer 144 of the thin film transistor 100. The source electrode 852 and the drain electrode 854 of the driving transistor 706 are counterparts of the source electrode 152 and the drain electrode 154 of the thin film transistor 100. Each constituent of the driving transistor 706 can be formed of a similar material, manufactured in a similar manner, and used for a similar purpose as the corresponding constituent of the thin film transistor 100.

In the present embodiment, the light emitting pixel 708 includes a light emitting layer 872, a top electrode 874, and an extended electrode 890. The extended electrode 890 may penetrate through a cap film 880 that serves to provide insulation, surface planarization, and protection of the transistor, and be electrically connected to the drain electrode 854 of the driving transistor 706. The source electrode 852 and the top electrode 874 form a pair of an input electrode and an output electrode. On part of the extended electrode 890, which is electrically connected to the drain electrode 854 of the driving transistor 706, the light emitting layer 872 and the top electrode 874 constituting the light emitting pixel 708 are arranged in the stated order in the direction substantially perpendicular to the main surface 812 of the substrate 810.

The light emitting layer 872 may be formed of semiconductors that emit light when a voltage is applied to the semiconductors. Furthermore, the light emitting layer 872 may have a multi-layered structure formed by a plurality of semiconductor layers having different functions. The light emitting layer 872 can be formed by coating or vacuum deposition, for example. The top electrode 874 and the extended electrode 890 can be formed of a similar material to the source electrode 852 or drain electrode 854.

The above description discloses a light emitting device including a light emitting element, and a semiconductor device that is coupled to the light emitting element and controls the light emission of the light emitting element. The semiconductor device includes a first metal oxide layer, a second metal oxide layer that is greater in sheet resistance than the first metal oxide layer, a pair of an input electrode and an output electrode that are electrically connected to the first metal oxide layer, and a control electrode that controls an impedance between the input electrode and the output electrode. The control electrode, the first metal oxide layer, and the second metal oxide layer are arranged in the stated order.

The above description also discloses a display device including a pixel, and a semiconductor device that is coupled to the pixel and controls the display of the pixel. The semiconductor device includes a first metal oxide layer, a second metal oxide layer that is greater in sheet resistance than the first metal oxide layer, a pair of an input electrode and an output electrode that are electrically connected to the first metal oxide layer, and a control electrode that controls an impedance between the input electrode and the output electrode. The control electrode, the first metal oxide layer, and the second metal oxide layer are arranged in the stated order.

### <Experimental Example 1>

In accordance with the process shown in Figs. 2 to 5, the thin film transistor 100 can be formed which includes the substrate 110, the control electrode 120, the insulating layer 130, the first metal oxide layer 142, the second metal oxide layer 144, and the input and output electrodes 150 in the stated order. The substrate 110 may be a glass substrate (available from Coming, 1737). Polysilicon can be deposited by CVD as the control electrode 120. SiO₂ can be deposited by CVD as the insulating layer 130.

An In-doped zinc tin oxide layer can be formed by sputtering as the first metal oxide layer 142. The sputtering target used may be a sintered body of zinc tin oxide. The first metal oxide layer 142 can be doped with In by disposing a chip containing In on the erosion portion of the target. The chip may have a size of 5 mm × 5 mm and a thickness of 1 mm. The sputtering operation may be controlled to continue for one hour under the conditions that a gas mixture of oxygen and Ar is supplied to a chamber of the sputtering apparatus, the pressure within the chamber is set to 0.5 Pa, the substrate temperature is set to 200 C°, and the sputtering power is set to 50W In this manner, the first metal oxide layer 142 having a thickness of approximately 10 nm can be provided.

A zinc tin oxide layer can be formed by sputtering as the second metal oxide layer 144. The sputtering operation may be controlled to continue for one hour under the conditions that a gas mixture of oxygen and Ar is supplied to a chamber of the sputtering apparatus, the pressure within the chamber is set to 0.5 Pa, the substrate temperature is set to 200 C°, and the sputtering power is set to 50W. After this, an Au thin film is formed by sputtering as the input and output electrodes 150. In this manner, the thin film transistor 100 can be manufactured. In the above-described manner, a normally-off transistor can be manufactured.

### <Comparative Experimental Example>

A thin film transistor having a similar structure to the thin film transistor of Experimental Example 1 can be manufactured, except for that it does not have the second metal oxide layer 144 and has the source electrode 152 and drain electrode 154 in contact with the first metal oxide layer 142.

### <Experimental Example 2>

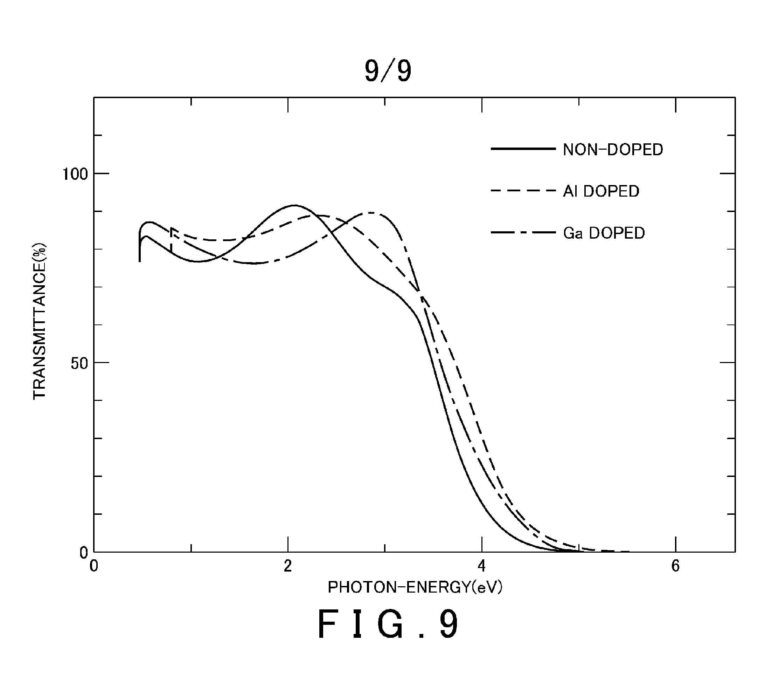

Fig. 9 shows how the optical transmittance of zinc tin oxides varies depending on dopants. In Fig. 9, the horizontal axis represents the photon energy [eV] of the light emitted to the zinc tin oxides, and the vertical axis represents the transmittance [%] of the zinc tin oxides. In Fig. 9, the solid line represents the optical transmittance of a non-doped zinc tin oxide, the dashed line represents the optical transmittance of an Al-doped zinc tin oxide, and the dashed-dotted line represents the optical transmittance of a Ga-doped zinc tin oxide.

The zinc tin oxides were deposited by RF sputtering by using a sintered body of zinc tin oxide as a target. To form the Al-doped zinc tin oxide, a metal chip made of Al was disposed on the erosion portion of the target. The chip had a size of 5 mm × 5 mm and a thickness of 1 mm. The dopants in the chip had a purity of 99.9 % or higher. To form the Ga-doped zinc tin oxide, a sintered body pellet of gallium oxide (Ga₂O₃) was disposed in place of the chip. The sintered body pellet had a diameter of 10 mm and a thickness of 3 mm.

A glass substrate (available from Corning, 1737), the target, and the chip were placed in a chamber of the sputtering apparatus and sputtering was then performed with an argon (Ar) gas being supplied to the chamber, so that the metal oxides were deposited on the glass substrate. The sputtering operation was controlled to continue for one hour with the pressure within the chamber being set to 0.5 Pa, the substrate temperature being set to 200 C°, and the sputtering power being set to 50W The zinc tin oxides obtained by the above sputtering operation had a thickness of approximately 100 nm.

The optical transmittance was measured by using an ultraviolet-visible-near-infrared spectrophotometer (available from JASCO Corporation, V-670). As seen from Fig. 9, the Al-doped or Ga-doped zinc tin oxides have a higher energy at the optical absorption edge than the non-doped zinc tin oxide. The above proves that the above-described configurations can realize a normally-off transistor having electrodes made of transparent materials and using a reduced amount ofIn.

Although some aspects of the present invention have been described by way of exemplary embodiments, the technical scope of the present invention is not limited to the above-described embodiments. It is obvious for the person skilled in the art to change or improve the above-described embodiments in various manners within the scope of the appended claims, and such changes or improvements may be also considered to fall within the technical scope of the present invention.

## Claims

1. A semiconductor device comprising:
a first oxide layer;
a second oxide layer that is greater in sheet resistance than the first oxide layer;
a pair of an input electrode and an output electrode that are electrically connected to the first oxide layer; and
a control electrode that controls an impedance between the input electrode and the output electrode, wherein
the control electrode, the first oxide layer, and the second oxide layer are arranged in the stated order.

2. The semiconductor device as set forth in Claim 1, wherein
the first and second oxide layers are each formed of a metal oxide.

3. The semiconductor device as set forth in Claim 2, wherein
the second oxide layer contains one or more elements selected from the metal element(s) contained in the first oxide layer.

4. The semiconductor device as set forth in any one of Claims 1 to 3, wherein
the second oxide layer has a sheet resistance exceeding 1 × 10⁵ Ω/□.

5. The semiconductor device as set forth in any one of Claims 1 to 4, wherein
the first oxide layer contains one or more elements selected from Zn and Sn.

6. The semiconductor device as set forth in any one of Claims 1 to 4, wherein
the first oxide layer contains one or more elements selected from the element group consisting of In, Sn, Zn, and Mg, and
the second oxide layer is substantially free from In.

7. The semiconductor device as set forth in Claim 6, wherein
the first oxide layer contains In.

8. The semiconductor device as set forth in Claim 7, wherein
the In concentration varies in the first oxide layer, and
the closer to the control electrode, the higher the In concentration.

9. The semiconductor device as set forth in any one of Claims 1 to 8, wherein
the first oxide layer is higher in carrier mobility than the second oxide layer.

10. The semiconductor device as set forth in any one of Claims 1 to 9, wherein
the second oxide layer is higher in oxygen concentration than the first oxide layer.

11. The semiconductor device as set forth in any one of Claims 1 to 10, wherein
the second oxide layer is greater in the energy gap of a forbidden band than the first oxide layer.

12. The semiconductor device as set forth in any one of Claims 1 to 11, wherein
the second oxide layer contains a metal element that constitutes an oxide that generates carriers a majority of which are holes, and
the second oxide layer is higher in concentration of the metal element than the first oxide layer.

13. The semiconductor device as set forth in any one of Claims 1 to 12, wherein
the second oxide layer contains one or more elements selected from the group consisting of Al, Zr, Mo, Cr, W, Nb, Ti, Ga, Hf, Ni, Ag, V, Ta, Fe, Cu, Pt, Si, and F.

14. A transistor substrate comprising the semiconductor device as set forth in any one of Claims 1 to 13.

15. A light emitting device comprising:
a light emitting element; and
a semiconductor device that is coupled to the light emitting element and controls the light emission of the light emitting element, wherein
the semiconductor device is the semiconductor device as set forth in any one of Claims 1 to 13.

16. A display device comprising;
a pixel; and
a semiconductor device that is coupled to the pixel and controls the display of the pixel,
wherein
the semiconductor device is the semiconductor device as set forth in any one of Claims 1 to 13.

17. A method for manufacturing a semiconductor device, the method comprising the steps of providing a substrate;
forming a first oxide layer;
forming a second oxide layer that is greater in sheet resistance than the first oxide layer; forming a pair of an input electrode and an output electrode that are electrically connected to the first oxide layer; and
forming a control electrode that controls an impedance between the input electrode and the output electrode.
